(19) Europäisches Patentamt
European Patent Office
Office européen des brevets

(11) Publication number: **0 186 172**
**B1**

(12) # EUROPEAN PATENT SPECIFICATION

(45) Date of publication of patent specification: **19.07.89**

(51) Int. Cl.$^4$: **G 03 G 13/01,** G 03 G 5/12

(21) Application number: **85116455.8**

(22) Date of filing: **22.12.85**

(54) **Electrophotographic color proofing method.**

(30) Priority: **26.12.84 US 686509**

(43) Date of publication of application:
**02.07.86 Bulletin 86/27**

(45) Publication of the grant of the patent:
**19.07.89 Bulletin 89/29**

(84) Designated Contracting States:
**BE CH DE FR GB LI NL**

(56) References cited:
**DE-B-2 906 500**
**GB-A-1 035 837**
**US-A-3 861 915**
**US-A-4 358 195**
**US-A-4 442 193**

(73) Proprietor: **EASTMAN KODAK COMPANY (a New Jersey corporation)**
**343 State Street**
**Rochester New York 14650 (US)**

(72) Inventor: **Ng, Yee Seung**
**Kodak Park**
**Rochester New York 14650 (US)**
Inventor: **Contois, Lawrence Edward**
**Kodak Park**
**Rochester New York 14650 (US)**
Inventor: **Mitchell, John Donald**
**Kodak Park**
**Rochester New York 14650 (US)**
Inventor: **Walling, James DaCosta**
**901 Elmgrove Road**
**Rochester New York 14650 (US)**

(74) Representative: **Parent, Yves et al**
**Kodak-Pathé Département Brevets et Licences**
**Centre de Recherches et de Technologie Zone Industrielle**
**F-71102 Chalon-sur-Saône Cédex (FR)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 186 172 B1

## Description

The present invention relates to an electrophotographic method for forming a multicolor image record comprising a plurality of overlapping color images on a receiving element. As used herein, statements that an image "overlaps" another image are intended to mean that an image lies, in whole or in part, over another image.

Color proofing is employed in the color printing field to form representative interim prints (also called proofs) from color separation components in the form of screened or unscreened separation negative or positive films or masks. Through the formation of such proofs, the separation components can be evaluated prior to the manufacture of expensive printing plates with such components to determine whether the separation components faithfully duplicate their contribution to the desired finished product, and whether the color separations formed from the separation components are in proper register. If so, the printing plate associated with each separation component is prepared and ultimately employed in the press run. As is often the case, however, the separation component requires repeated alteration to satisfy the user, an expensive proposition if new printing plates are prepared after each such alteration. Instead, inexpensive proofs serve in this pre-press evaluation of the separation components.

A number of systems are employed in the color-proofing area, and some are described in detail in U.S. Patent 4,425,417, issued January 10, 1984. For example, in one system, presensitized sheets are exposed to light through a separation silver halide negative and developed to provide a color separation image on a transparent support. A plurality of such color separation images on transparent supports are then overlaid in register on a paper support to provide a proof.

U.S. Patent 4,358,195, issued November 9, 1982, describes an electrophotographic proofing element upon which color toner images are sequentially formed and transferred to an element in register with previously formed and transferred toner images. The system described in that patent thus avoids the use of presensitized materials. However, like other systems, the electrophotographic color proofing system described in that patent requires that the registration of each color separation image with previously formed and transferred images take place during each toner-transfer stage of the process. Unfortunately, registration of toner separation images at the toner transfer stage of the process is an inherently slow process. Furthermore, proper registration of the images is dependent on virtually absolute dimensional stability of the receiver element to which the images are transferred throughout all the transfer steps. It will be appreciated that it is difficult to prevent stretch or shrinkage or other distortion of the element while it is subjected to pressure, heat or liquid toner media during development or transfer. When distortion occurs, image registration suffers. In addition, the transfer of the toner images from the electrophotographic proofing element to the receiver as described in U.S. Patent 4,358,195 can be incomplete, resulting in a lower-quality image, compared with the quality of an image achieved with substantially complete transfer of toner.

British Patent 1,035,837, on the other hand, describes an electrophotographic overprinting method in which color toner separation images are formed in sequence and in overlapping configuration on a photoconductive element for simulating, as the patent points out, the hue, intensity, transparency and overprinting characteristics of standard lithographic four-color ink systems. To provide for overprinting of the separation images directly on the photoreceptor, the patent teaches the use of whitish, light-colored or transparent waxy substances with its disclosed toners so as to avoid the blanketing effect of pigments in the toner of previously formed images upon recharging and reexposure to form subsequent images. It is apparent from this teaching that color quality is sacrificed for the sake of overprinting directly on the photoreceptor. Furthermore, the overprinted images are not transferable to another substrate, and the background against which the overprinted toners are viewed does not faithfully represent the print background against which lithographic inks are viewed after a press run.

The present invention solves the problem of simply and accurately forming a multicolor proof comprising a plurality of registered overlapping color separation toner images, wherein the colors and images are accurately representative of ultimate press run colors and images, the overlapping toner images are on a receiving element that provides a background accurately representative of the background in an ultimate press run, and the images on the receiving element are protected (e.g., against abrasion or other environmental physical or chemical degradation).

The color imaging method of the present invention involves use of an electrophotographic imaging element that comprises:

(a) a photoconductive layer on an electrically conductive substrate capable of transmitting actinic radiation to which the photoconductive layer is responsive and

(b) a dielectric support releasably adhered to the rest of the element and forming an electrostatically chargeable surface of the element, said support comprising said photoconductive layer, or an overcoat thereof.

In using the element so defined, the dielectric support surface is electrostatically charged, the photoconductive layer is imagewise-exposed to actinic radiation, and the element is contacted with an electrographic developer to form a first toner color image on the dielectric support. The imagewise exposure in forming the first toner image can be directed to the front surface or it can be directed to the rear surface of the element, and in the latter case actinic radiation passes through the substrate to the

photoconductive layer. However, in the formation of subsequent toner images overlapping the first toner image on the dielectric support, imagewise exposure of the photoconductive layer to actinic radiation is conducted through the radiation-transmissive, electrically conducting substrate. An advantage is that electrostatic field images faithfully corresponding to the exposure pattern are formed on the dielectric support despite the presence of toner images from previous imaging cycles that might otherwise interfere. A consequent advantage is that the toner materials can be chosen to provide colors accurately representative of ultimate press run colors, without concern about interfering with subsequent electrostatic field image formation.

Accordingly, the multicolor imaging method of the invention employs the above-defined imaging element to form a multicolor image record and can be further characterized by:

(I) forming a first color image on the dielectric support of the electrophotographic proofing element by:

(i) overall charging the surface of the dielectric support,

(ii) imagewise-exposing the photoconductive layer to actinic radiation to form a first electrostatic image on the surface of the dielectric support, and

(iii) developing the first electrostatic image with a first color developer composition to form the first color image,

(II) forming a second color image overlapping the first color image on the dielectric support by:

(iv) overall charging the surface of the dielectric support and first color image,

(v) while the dielectric support and first color image are still charged, imagewise-exposing the photoconductive layer to actinic radiation through the substrate to form a second electrostatic image on the surface of the dielectric support and first color image, and

(vi) developing the second electrostatic image with a second color developer composition to form the second color image,

(III) contacting the surface of the dielectric support having the color images thereon with a receiving element, and

(IV) transferring the dielectric support and color images to the receiving element to form the multicolor image record and peeling off the rest of the element.

The present invention marks the first time that a releasable dielectric support is utilized in combination with an actinic radiation-transmissive electrically conductive substrate in a color imaging element and method. In addition to the advantages previously described, the invention provides for convenient registration of all the images directly on the described electrographic imaging element before any transfer to the receiving element. Furthermore, substantially complete transfer of the overlapping color images to a receiving element of choice is effected as a consequence of simultaneous transfer with the dielectric support, to produce thereby a high-quality color proof which faithfully resembles the printed product that would be obtained in a full press run. The transferred dielectric support also provides protection for the overlapping toner images sandwiched between the dielectric support and the receiver in the form of abrasion-resistance, and also color stability, particularly if the toner colorants are vulnerable to light or aerial degradation.

A mode of practice of the invention will be described with reference to the drawings in which:

Figure 1 illustrates an electrophotographic imaging element for use in the method of the invention.

Figures 2 through 4 illustrate that part of the invention in which a first toner separation image is electrophotographically formed on the imaging element of Figure 1.

Figures 5 through 7 illustrate that part of the invention in which a second toner separation image is electrophotographically formed over the first toner separation image on the imaging element of Figure 4.

Figure 8 illustrates the imaging element of Figure 1 upon which four toner separation images have been sequentially formed in accordance with the method of the invention.

Figure 9 illustrates thermal transfer of the dielectric support and a composite toner image of four toner color separation images to a receiver element to form a color image record in accordance with the final step of the claimed invention.

In order to form overlapping toner separation images directly on an electrophotographic element, it is necessary to provide means by which the photoconductive portion of the element can be imagewise-illuminated in such a manner as to form latent electrostatic images on untoned, as well as toned, regions of the photoreceptor. Furthermore, after each toner separation image is formed in overlapping configuration, means should be provided to view the composite image resulting from such overlapping images on the print stock (usually paper) upon which the multicolor press run prints will be made after approval of the color proof. The present invention provides for these objectives and other advantages through the use of an electrically conducting substrate capable of transmitting actinic radiation to which the photoconductive layer is responsive, and through the use of a releasable dielectric support forming a charge-holding surface of the element.

An electrophotographic imaging element useful in the present invention comprises a photoconductive layer on an electrically conducting substrate capable of transmitting actinic radiation to the photoconductive layer, and a dielectric support releasably adhered to the rest of the element and forming an electrostatically chargeable surface of the element. The dielectric support, as previously noted, can comprise the photoconductive layer which releasably adheres to the electrically conductive substrate. In this case, the electrophotographic element comprises the photoconductive layer functioning also as the

dielectric support. Alternatively, the releasable dielectric support can comprise an overcoat releasably adhered to the photoconductive layer. The discussion below is directed predominantly to the use of such an element for purposes of illustrating the invention.

Any type of photoconductive material can be employed as the photoconductive layer which is capable of charge carrier formation under the influence of electrostatic charging and exposure to actinic radiation. Inasmuch as the imaging element utilized in the present method can be discarded after the formation of the image record, single-use photoconductive layers can be employed. Representative materials and layers include polyarylamines or arylalkane photoconductors as described, for example, in U.S. Patent 4,442,193. Such photoconductors include:

(1) arylamines, diarylamines, nonpolymeric and polymeric triarylamines such as tri-p-tolylamine;

(2) polyarylalkanes such as triphenyl methanes and tetraphenyl methanes, for example, bis(4-diethylamino)tetraphenyl methane;

(3) 4-diarylamino-substituted chalcones;

(4) nonionic cycloheptenyl compounds;

(5) compounds containing an:

$$=N—N= \qquad \text{I}$$

nucleus;

(6) organic compounds having a 3,3′-bis-aryl-2-pyrazoline nucleus;

(7) triarylamines in which at least one of the aryl radicals is substituted by either a vinyl radical or a vinylene radical having at least one active hydrogen-containing group;

(8) triarylamines in which at least one of the aryl radicals is substituted by an active hydrogen-containing group;

(9) any other organic compound which exhibits photoconductive properties such as those set forth in U.S. Patent 3,250,615 and Australian Patent 248,402, and the various polymeric photoconductors such as the photoconductive carbazole polymers described in U.S. Patent 3,421,891.

some photoconductive compositions, e.g., arylalkane leuco base photoconductors, are advantageously nonpersistently conductive and sensitive to radiation below 400 nm, but substantially insensitive to radiation above 400 nm. Arylalkane leuco base photoconductors are disclosed, for example, in U.S. Patent 4,442,193, and bear the structure:

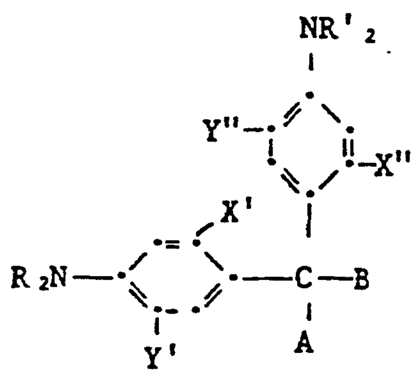

II

wherein:

each of R and R′ is selected from the group consisting of hydrogen, alkyl and aralkyl having 1—4 carbon atoms in the alkyl group;

each of X′ and X″ is selected from the group consisting of alkyl having 1 to 4 carbon atoms, alkoxy having 1—4 carbon atoms, hydroxyl and halogen;

each of Y′ and Y″ is selected from the group consisting of alkyl having 1—4 carbon atoms, alkoxy having 1—4 carbon atoms, hydroxyl, halogen and hydrogen; and

each of A and B is:

(1) hydrogen, with the proviso that A and B are not both hydrogen;

(2) aryl such as phenyl, α-naphthyl, β-naphthyl, 9-anthryl and substituted derivatives thereof wherein the substituent is dialkylamino, alkylamino, amino, alkyl, alkoxy, hydroxyl or halogen;

(3) an aliphatic alkyl group having 1—18 carbon atoms, e.g., methyl, ethyl, propyl, butyl, isobutyl, octyl, dodecyl, etc., including a substituted alkyl group having 1—18 carbon atoms;

(4) a cycloalkyl group having 4—8 carbon atoms in the cyclic nucleus, e.g., cyclobutyl, cyclohexyl, cyclopentyl, etc., including a substituted cycloalkyl group; or

(5) a cycloalkenyl group having 4—8 carbon atoms in the cyclic nucleus, e.g., cyclohex-3-enyl, cyclopent-3-enyl, cyclobut-2-enyl, cyclohex-2-enyl, etc., including a substituted cycloalkenyl group.

Representative Formula II arylmethane photoconductors are set forth in Table 2 of U.S. Patent 4,442,193. Particularly useful photoconductive compositions comprise crystallization-inhibiting mixtures of

two or more of the arylalkane leuco base photoconductors are disclosed in U.S. Patent 4,301,226, issued November 17, 1981. One such crystallization-inhibiting mixture comprises three arylmethane photoconductors: bis(4-N,N-diethylamino-2-methylphenyl)-4-methylphenyl-methane, 1,1-bis(4-N,N-diethylamino-2-methylphenyl)-2-methyl-propane and 4,4′-bis(diethylamino)-2,2′-dimethyl-triphenylmethane.

The total amount of photoconductor may vary widely, but usually ranges from about 5 to about 40 weight percent based on the solvent-free weight of the photoconductive layer.

Photoconductors can be coated alone, or can be incorporated into an electrically insulating binder and coated, as a photoconductive layer on a transparent electrically conductive support to form all or a portion of the electrophotographic imaging element utilized in the invention, depending on whether the photoconductive layer is also the releasable dielectric support.

When an electrically insulating binder is used in preparing the photoconductive layer, any such binder can be employed. Particularly advantageous binders are film-forming, hydrophobic polymeric binders having fairly high dielectric strength. Materials of this type comprise styrene-butadiene copolymers; silicone resins; styrene-alkyd resins; silicone-alkyd resins; soya-alkyd resins; poly(vinyl chloride); poly(vinylidene chloride); vinylidene chloride-acrylonitrile copolymers; poly(vinyl acetate); vinyl acetate-vinyl chloride copolymers; poly(vinyl acetals) such as poly(vinyl butyral); polyacrylic and polymethacrylic esters such as poly(methyl methacrylate), poly(*n*-butyl methacrylate), poly(isobutyl methacrylate); polystyrene; nitrated polystyrene; polymethylstyrene; isobutylene polymers; polyesters such as poly[ethylene-co-alkylenebis(alkyleneoxyaryl)phenylenedicarboxylate]; phenolformaldehyde resins; ketone resins; polyamides; polycarbonates; polythiocarbonates; poly[ethylene-co-isopropylidene-2,2-bis-(ethyleneoxyphenylene)terephthalate]; copolymers of vinyl haloarylates; poly(ethylene-co-neopentyl terephthalate); and vinyl acetate such as poly(vinyl-*m*-bromobenzoate-co-vinyl acetate).

Especially useful binders are polyesters having relatively high glass transition temperature (Tg) values and being able to accomodate high photoconductor concentrations without allowing the photoconductor to migrate from the photoconductive layer toward the dielectric support. If such migration occurs, photoconductive compounds, often undesirably colored, might ultimately pass to the receiving element when the support is transferred in the color imaging method described herein. Use of polymers with a relatively high Tg, moreover, prevents unwanted charge injection when the photoconductive layer is also the releasable dielectric support, as discussed in greater detail below. Examples of such relatively high Tg polyesters are poly[(4,4′-norbornylidene)bisphenoxyethylene-co-ethylene terephthalate]; poly[(4,4′-hexahydro-4,7-methanoindene-5-ylidene)bisphenoxyethylene-co-ethylene terephthalate]; poly[(isopropylidene)bisphenoxyethylene-co-ethylene naphthoate]; poly(1,2-propylene naphthoate); poly[(isopropylidene)bisphenoxyethylene-co-1,2-propylidene naphthoate]; poly[(4,4′-isopropylidene)-bisphenoxyethylene-co-bis(1,2-propylene)naphthoate]; and poly[1,2-propylene methylsuccinate-co-naphthoate].

The photoconductive layers employed in some embodiments of the above-defined imaging element are advantageously selected to provide sensitivity below 400 nm only and to exhibit nonpersistent conductivity. (400 nm represents the approximate low spectral wavelength of transition between visible and nonvisible light; persistent conductivity refers to the lengthy lingering conductivity of some photoconductive materials in exposed regions.) Sensitivity only below 400 nm permits charging, exposure and development of the photoconductive composition while in visible light. Nonpersistent conductivity is advantageous, because the photoconductive layer is to be cycled through a charge-expose-develop sequence a plurality of times to produce a multicolor image record. If the photoconductive layer remains conductive for a lengthy period in light-struck regions from preceding exposure steps, unwanted image formation from such preceding steps will contaminate subsequent desired images, unless each subsequent cycle is delayed until the lengthy period of conductivity passes. Such delays are unnecessary if the photoconductor has already become nonconductive again by the time the element is otherwise ready for the next cycle. Specifically, it is desirable that the period during which the photoconductive layer remains conductive after exposure to actinic radiation be less than 30 seconds.

If it is desired to further enhance the photosensitivity of the photoconductive layer, sensitizers can be incorporated therein, e.g., sensitizers for the region of the electromagnetic spectrum below 400 nm. Particularly useful sensitizers providing such sensitivity are described in U.S. Patent 4,442,193. These sensitizers are 1,4,5,8-naphthalene dicarboxïmide compounds and are particularly useful as sensitizers for arylalkane leuco base photoconductors. The preferred structure of these compounds is:

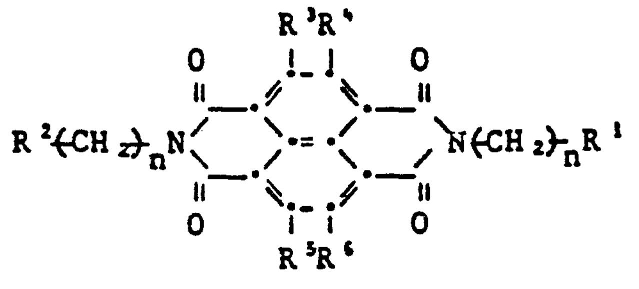

III

wherein:

$R^1$ and $R^2$, which may be the same or different, represent aryl, such as phenyl or naphthyl, or aryl substituted with alkyl, alkoxy, perfluoroalkyl or perfluoroalkoxy groups having 2—20 alkyl carbon atoms; sulfonyl; sulfone; sulfonamide; nitrile; or nitro groups;

$R^3$, $R^4$, $R^5$ and $R^6$, which may be the same or different, represent hydrogen, alkyl having 1—4 carbon atoms, alkoxy having 1 to 4 carbon atoms, or halogen; and

n is 0 to 3.

Preferably, $R^1$ and $R^2$ in Formula III are phenyl or phenyl substituted with alkyl, alkoxy or perfluoroalkyl, and $R^3$, $R^4$, $R^5$ and $R^6$ are hydrogen.

Representative 1,4,5,8-naphthalene bis-dicarboximide sensitizers include N,N'-bis[*p*-(*n*-butyl)phenyl]-1,4,5,8-naphthalene bis-dicarboximide; N,N'-bis(*m*-trifluoromethyl phenyl)-1,4,5,8-naphthalene bis-dicarboximide; N,N'-bis(3-phenylpropyl)-1,4,5,8-naphthalene bisdicarboximide; N,N'-bis[*p*-(*n*-octyloxy)-phenyl]-1,4,5,8-naphthalene bis-dicarboximide; N,N'-bis(phenyl)-1,4,5,8-naphthalene bisdicarboximide.

The amount of dicarboximide employed can vary widely in accordance with the degree of sensitization desired. Effective amounts of the sensitizer represented by Structure III can vary widely to provide sufficient speed to the photoconductive layer. The optimum concentration in any given case will vary with the specific photoconductor and sensitizing compound used. Substantial speeds can be obtained where a sensitizer according to Structure III is added in a concentration range from about 0.0001 to about 30 percent based on the weight of the composition on a dry basis. A preferred sensitizer concentration range is from about .005 to about 5.0 percent.

The thickness of the photoconductive layer can vary depending on the type of photoconductors employed in the layer, speeds desired and other factors. Photoconductive layer thicknesses in the range from 2 to 20 micrometers are usually useful, while layer thicknesses of from 5 to 13 micrometers are usually preferred.

As can be seen from the foregoing discussion, the photoconductive layer is often colored as a result of the photoconductive, as well as sensitizing, constituents in the layer. For this reason, it is preferred to use a separate overcoat on the photoconductive layer as the releasable dielectric support; otherwise, after transfer of the composite toner image to a receiver as discussed below, the resulting color image record may contain undesirable hue as a result of constituents in the photoconductive layer, if the latter is employed as the releasable dielectric support. It will be appreciated, however, that transparent and colorless photoconductive layers can be prepared for use in the method, in which case such minor difficulties would be overcome. Furthermore, the presence of any hue from the photoconductive layer may not be objectionable in some user applications.

In a preferred mode of practice of the invention, a separate dielectric support is releasably adhered to the photoconductive layer. To facilitate such releasability, the photoconductive layer can contain release addenda, e.g., block copolyesters of polysiloxanes corresponding to the structure:

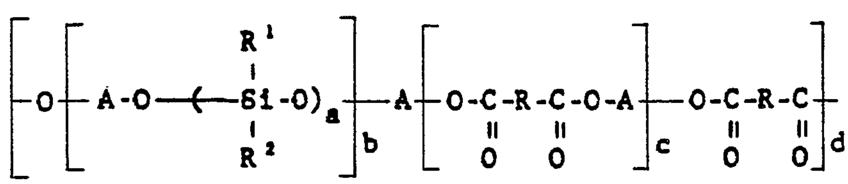

wherein:

R is an alkylene radical containing at least 3 carbon atoms;

$R^1$ is an alkyl radical and $R^2$ is an alkyl, alkaryl, aralkyl or aryl radical;

A is an alkylene or arylene radical;

a is an integer of at least 10;

b is an integer of at least 1;

c is an integer of at least 2; and

d is an integer of at least 2;

as described in U.S. Patent 3,861,915. Such release agents can be prepared by reacting dihalopoly-diorganosiloxane with an aromatic or aliphatic diol to form the dihydroxypolydiorganosiloxane subsequently reacted with an aliphatic dicarboxylic acid halide to form the block copolyester shown.

Alternative release agents which can also be used are:

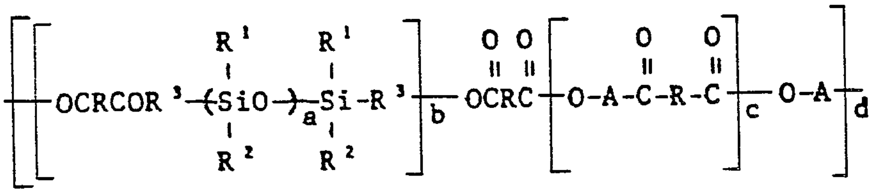

wherein:

a, b, c, d, R, $R^1$, $R^2$ and A are the same as described above and

$R^3$ is an alkyl group of at least 2 carbon atoms synthesized by reacting a diol-containing polydiorganosiloxane and an aliphatic or aromatic diol with an aromatic or aliphatic dicarboxylic acid chloride to form the alternative block copolyester indicated.

A second alternative block copolyester release agent corresponding to the structure:

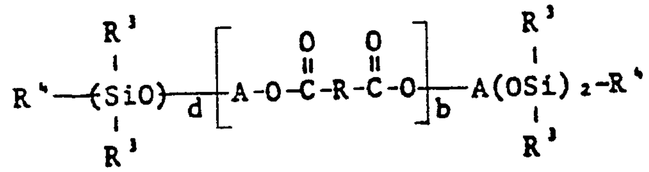

wherein:

R, A, $R^3$, b and d are the same as above and $R^4$ is an alkyl group, can be employed. The second alternative is formed by reacting a monohalopolydiorganosiloxane polymer with an aliphatic or aromatic diol and an aromatic or alkyl dicarboxylic acid halide.

Representative block copolyesters which can be employed as release agents include poly[4,4'-isopropylidenediphenylene-co-block-poly-(dimethylsiloxanediyl)sebacate]; poly[1,4-butylene-co-block-poly-(dimethylsiloxanediyl)sebacate]; poly[4,4'-isopropylidenediphenylene-co-block-poly(dimethylsiloxanediyl)glutarate; poly(4,4'-isopropylidenediphenylene terephthalate-co-azelate 50/50-b-dimethylsiloxane); poly(4,4'-isopropylidene-diphenylene adipate-b-dimethylsiloxane); poly(4,4'-[hexahydro-4,7-methanoinden-5-ylidene]bis(phenylene)carbonate-b-dimethylsiloxane) and poly[1,4-butylene-co-block-poly-(dimethyl-siloxanediyl)adipate].

The concentration of the release agent which can be used to facilitate release of the dielectric support as desired can vary widely. A useful concentration of release agent in some cases is from about 0.05 percent to about 2 percent by weight of the photoconductive layer.

The electrically conducting substrate employed in the above-defined imaging element can comprise any substrate material which is electrically conducting and transmits actinic radiation to which the photoconductive layer is responsive. As noted previously, preferred elements are sensitive to ultraviolet radiation below 400 nanometers, in which case the electrically conducting substrate should transmit radiation below 400 nanometers. In this manner, the photoconductive layer can be imagewise-exposed to actinic radiation through such substrate to form electrostatic field image patterns on the dielectric support even though the latter contains toner images from previous cycles.

The conducting substrate, furthermore, either can be a single layer of appropriate electrical conductivity and transmissive capability, or a multilayer substrate comprising, for example, an electrically conducting layer on a polymeric film. In the latter case, the polymeric film can comprise any suitable polymer (e.g., cellulose acetate, poly(ethylene terephthalate), polyethylene or polypropylene) and the conducting layer can be any well-known spectrally transmissive electrically conducting material coated onto the film. Some conductive layers adequate for use in the present method comprise a metal-containing semiconductor compound such as cuprous iodide, silver iodide, or others as disclosed, for example, in U.S. Patent 3,428,451.

The conductive layer can also contain addenda to improve the uniformity of charge on the imaging element during use. In some instances, when elements are overall charged prior to exposure, the charge so applied is not entirely uniform. To avoid or minimize such nonuniformity, the conductive layer can also contain certain addenda such as fluorocarbon surfactants. Other addenda which can be incorporated into the conductive layer to minimize nonuniform charging include silicones and polyalkylene oxides such as copolymers of polyethylene oxide and polypropylene oxide, in the range from 0.0002 to 20 percent, by weight, based on the total weight of the conductive layer.

The conductivity of the defined substrate is generally determined in terms of surface resistivity. The surface resistivity of useful substrates is less than $10^{11}$ ohms per square and is preferably less than $10^5$ ohms per square.

As is well-known to those skilled in the art, many arrangements of photoconductive layers on electrically conducting substrates result in elements bimodal in nature; i.e., they are capable of producing developable electrostatic images when charged either negatively or positively and exposed to actinic radiation. However, in some of these elements, the conducting substrate has a tendency to indiscriminantly inject either positive or negative charge carriers into the photoconductive layer before exposure, preventing operation in either the negative or positive charging mode. In view of such behavior, the imaging element in the present method can also contain a barrier layer between the electrically conducting substrate and the photoconductive layer to prevent unwanted charge carriers from entering the photoconductive layer. Representative barrier layers include cellulose nitrate layers as disclosed in U.S. Patent 3,640,708 and others as disclosed in column 6 of U.S. Patent 3,428,451.

In accordance with a preferred mode of practice of the invention, a dielectric support in the form of an overcoat is releasably adhered to the photoconductive layer to form a chargeable surface of the imaging

element. Anong other things, the toner separation images are overlapped in sequence on the dielectric support and the toner images, together with the support, are transferred from the photoconductive layer to a suitable receiver to form the desired color image record. Because the receiver is usually representative of the print stock upon which the press run will take place, the dielectric support is preferably optically transparent to facilitate viewing of the toner composite image against the receiver, thereby simulating a press run print.

The dielectric support can be any material capable of retaining an electrostatic charge applied to its surface. In general, any chargeable polymeric material can be employed. Preferably the support is such that, with toner formed on its surface as described herein for the color imaging process, it forms a barrier to (i.e., prevents) dark injection of charge from such toner into the photoconductive layer. The support preferably also prevents the transmission to its surface of charge carriers photogenerated within the photoconductive layer. If the releasable dielectric support comprises the photoconductive layer, charge injection from the surface thereof to within the layer or from within the layer to the surface can be minimized or avoided through the use of polymers with high glass transition temperatures (Tg) as polymeric binders in the photoconductive layer. In this regard, polymers with Tg's from about 100°C and higher have been found useful to prevent unwanted charge injection. Alternatively, polymers with Tg's below 100°C can be employed, and charge injection can still be prevented, if the Tg of the photoconductor employed is such that the Tg of the polymer and photoconductor in combination is greater than 100°C. When the releasable dielectric support displays such barrier properties, the quality of the overlapping color separation images is improved.

Representative polymers which can be employed in the dielectric support include polyesters, vinyl polymers, acrylic polymers and cellulosic polymers. For example, such materials as polyvinyl acetate, cellulose acetate butyrate and copolymers of vinylacetate and crotonic acid can be employed. Mixtures of cellulose acetate butyrate with either polyvinyl acetate or with copolymers of vinylacetate and crotonic acid can also be employed.

The thickness of the dielectric support can vary to provide the desired electrical and optical characteristics. Usually, the dielectric support will have a thickness in the range from about 0.5 to about 5.0 micrometers, and preferably a thickness from about 1.5 to about 3.0 micrometers.

The dielectric support can be applied to the photoconductive layer by any of a variety of ways employed in the art to form overcoated layers. For example, the support can be applied from a coating solution of the polymeric binder for the support and a coating solvent. To provide coating and layer uniformity, the coating solution can also contain a surfactant such as a silicone fluid, for example, a methylphenyl silicone fluid.

Further advantages can also be obtained in some embodiments when the dielectric support contains an agent to improve ambient stability. Useful stabilizing agents include condensates of ethylene oxide with hydrophobic bases formed by condensing propylene oxide with propylene glycol (polyethylene-polypropylene oxides). These condensates are available commercially as Pluronics® from Wyandotte Chemicals Corp., a corporation of Wyandotte, Michigan, U.S.A. Such condensates appear to provide a degree of hygroscopicity and thereby aid in the electrostatic image-forming process at lower levels of relative humidity. The concentration of the stabilizing agent can be from 0.1 to 5 percent by weight, based on the total weight of the dielectric support.

Fig. 1 depicts an imaging element 1 to be used in a preferred mode of practice of the invention. Element 1 comprises a dielectric support 2 releasably adhered to a photoconductive layer 3 to form a chargeable surface of element 1. Photoconductive layer 3, in turn, overlies a transparent, electrically conductive substrate 4 which in the embodiment shown comprises an electrically conducting layer 5 on a supporting film 6. Optionally (not shown), element 1 can contain a barrier layer between the photoconductive layer 3 and the electrically conductive substrate 4 to facilitate bimodality as described elsewhere herein.

Figs. 2 through 4 show the formation of the first toner image on the surface of the dielectric support in a preferred mode of practice of the invention. Initially (Fig. 2), the dielectric support 2 is overall-charged with an appropriate charging means such as a corona charger (not shown) to form a uniform potential on the outer surface of the dielectric support 2. Upon being so charged, in this case positively, a balancing negative charge forms uniformly in the conductive layer 5 as shown. When the photoconductive layer 3 is imagewise-exposed through the conductive substrate 4 to actinic radiation 8 transmitted by overall exposure of a color separation transparency 9 as shown in Fig. 3, mobile charge carriers, in this case positively charged holes, are formed in the exposed regions of photoconductive layer 3 and migrate toward the interface of photoconductive layer 3 and conducting layer 5. (Nonmobile charge carriers not shown, namely, electrons, remain randomly distributed throughout the exposed regions of the photoconductive layer.) Accordingly, the electric-field strength at the dielectric support surface in exposed regions is diminished while the field strength in unexposed regions remains approximately the same. As a result, a differential electrostatic field pattern is formed on the dielectric support 2 corresponding to the pattern on the transparency. When the electrostatic differential pattern is contacted with a positively charged electrographic developer composition, positively charged toner particles adhere to exposed regions exhibiting diminished field strengths and thus form the first toner image 10 as shown in Fig. 4. Any known electrographic developer can be used, the choice depending solely on the desirability of using a developer comprising a toner having a color faithfully representative of the color of the corresponding image that can

be obtained in a full press run. A development electrode (not shown) can also be employed in the development zone above dielectric support 2. The development electrode is usually charged to the same polarity and potential as the unexposed regions of the dielectric support to enhance the development efficiency in large solid areas in accordance with known procedures. In these illustrations, the first toner separation image 10 is a negative sense image in which image optical density corresponds inversely to optical density in the separation transparency. (It will be appreciated by those skilled in the art, however, that toner particles can be directed to unexposed regions where the surface potential is greater by using, in the case illustrated, negatively charged developers instead.) After developing the first charge pattern, the toner image 10 can be fixed by pressure, by heat, by solvent treatment or through the use of self-fixing developer formulations as disclosed, for example, in copending European Patent Application 0098084, published on January 11, 1984.

Figs. 5 through 7 depict the formation of the second toner image overlapping the first toner image on the dielectric support. Although the figures do not show it, any residual charge remaining on element 1 after forming the first toner image can be erased by overall exposure to actinic radiation. Thereafter, element 1 is again charged positively as shown in Fig. 5 to form a uniform potential on both toned and untoned surface regions of dielectric support 2. Imagewise exposure of the photoconductive layer 3 through conductive substrate 4 as shown in Fig. 6 to actinic radiation 11 transmitted by a second color separation transparency 12 (which is different from color separation transparency 9 shown in Fig. 3) produces a second differential charge pattern in the same manner as discussed above. Development with a second developer composition, also charged positively, results in a second toner image 13 overlapping the first toner image 10, as shown in Fig. 7.

In the formation of a multicolor proof, the above charge-expose-develop steps can be repeated at least two more times to form a four-color image as shown in Fig. 8 wherein third (14) and fourth (15) toner images overlap first (10) and second (13) toner images. When the color of these toners is respectively black, cyan, magenta and yellow for each image, a full color composite image results on dielectric support 2 corresponding to the composite image desired in a press run.

After formation of the desired number of images, the dielectric support and the images thereon are brought into contact with a receiver element and transferred from the imaging element to the receiver element to form the desired multicolor image record. Fig. 9 depicts one mode of such transfer wherein dielectric support 2 on element 1 is brought into contact with a receiver element 16 in a nip formed between rollers 17 and 18. By the application of sufficient pressure and heat within the nip, dielectric support 2 and the composite of images 10, 13, 14 and 15 become laminated to the receiver 16 as shown to form a color proof 19. Alternatively (not shown), the dielectric support carrying the toner images can be brought into planar contact — as opposed to rolling contact — with the receiver element where lamination is effected again by heat and pressure provided, for example, by a platen supporting either the receiver or the imaging element. Thereafter, the rest of imaging element 1 is stripped from the dielectric support to complete the transfer of the support and composite image to the receiver, forming thereby the desired color image record comprising, in sequence, the receiver, the composite image and the dielectric support.

In the lamination and subsequent transfer of the dielectric support and composite image, a temperature above the Tg of the polymeric material in the dielectric support can be chosen so as to soften and tackify the support. The dielectric support, moreover, can be chosen from among materials adhering preferentially to the receiver, thereby facilitating transfer of the support and composite image to the receiver. Representative temperatures employed during the transfer step extend from 100° to 115°C; however, the system can operate over a wider temperature range depending on the choice of materials. Practical considerations in selecting the upper temperature point include the possibility that either the receiver or the imaging element will distort at the temperature selected, as well as the propensity of components in the photoconductive layer to oxidize at the temperature chosen, which would tend to impart undesirable background coloration to the final image record if any of these components transfer to the receiver. The lower limit of the temperature employed to effectuate transfer, moreover, is governed to a large extent by the permanency of adhesion of the support and composite image to the receiver. If the support and image are easily removed from the receiver, the transfer temperature can be increased to enhance the permanency of such adhesion.

Pressures employed to transfer the support and composite image to the receiver can also vary widely. Planar transfers (i.e., transfers effected while the dielectric support and receiver are in full planar contact) have been successful using relatively low pressures from 30 to 40 pounds per square inch (from 0.207 to 0.276 megapascals, MPa). Optimum transfers have been effected with a pressure of 35 psi (0.276 MPa); however, departures from such pressures are appropriate depending, for example, on the roughness of the receiver surface. Preferably, the receiver surface should be smooth, as rough surfaces tend somewhat to inhibit transfer of the support and composite image.

The receiver element to which the dielectric support and composite toner image are transferred can be any suitable material against or through which the toner image is desired to be viewed. As noted earlier, the receiver is preferably print stock, such as paper, upon which the pressure run will be conducted. The receiver can also be of transparent material such as a polymeric film. With respect to the latter, the present invention also contemplates, as an embodiment, transfer of the composite toner image and dielectric support to image-bearing elements such as microfilm or microfiche so that the composite color image

forms information in addition to image information already present on such image-bearing elements. In addition, the invention contemplates the use of nonbirefringent translucent polymeric materials such as cellulose esters for use as the receiver. Receivers manufactured from such materials are suited for use in forming three-color filter arrays by the process described herein involving the formation of filter array matrices of the complementary colorants cyan, magenta and yellow in the respective color toner steps. If desirable, the receiver can also contain a suitable overcoat layer adapted to soften under the influence of pressure and heat during the transfer step. In this manner, the adhesion of the dielectric support and composite toner image to the receiver can be enhanced.

The following preparations and example are provided to aid in the practice and understanding of the invention.

Preparation A

Electrophotographic elements for the inventive method

An electrophotographic element comprising, in sequence, a photoconductive layer, a barrier layer, and an electrically conductive substrate comprising a conductive layer and a supporting film was prepared. A dielectric support was releasably adhered to the photoconductive layer. The photoconductive layer contained:

(a) as an electrically insulating binder, a blend of two polyesters containing 94%, based on the total weight of binder, of a terpolymer of terephthalic acid, 2,2-bis[4(β-hydroxyethoxy)phenyl]propane and ethylene glycol; and about 6%, based on the total weight of binder, of a copolymer of terephthalic acid, ethylene glycol and neopentyl glycol;

(b) 22.5%, based on the total weight of the layer, of equal parts by weight of three photoconductive compounds. The three compounds were 4,4′-bis(diethylamino)-2,2′-dimethyltriphenylmethane, 1,1-bis(4-N,N-diethylamino-2-methylphenyl)-2-methylpropane, and bis(4-N,N-diethylamino-2-methylphenyl)-4-methylphenylmethane;

(c) 2%, by weight of the layer, of the sensitizer N,N-bis[*p*-(n-butyl)phenyl]-1,4,5,8-naphthalenebis-dicarboximide; and

(d) 0.25%, by weight of the layer, of the siloxane-release agent poly(Bisphenol A)adipate-poly(dimethylsiloxane) to facilitate thermal release of the dielectric support.

The barrier layer was optically transparent and comprised cellulose nitrate.

The electrically conductive layer of the conductive substrate was optically transparent and comprised (a) cuprous iodide in a binder containing poly(vinyl formal) with 5—7 weight percent, based on binder, poly(vinyl alcohol) and 40—50 weight percent poly(vinyl acetate) to provide a surface resistivity of 1 × $10^4$ ohms/square, and (b) 0.26 weight percent, based on the weight of the layer, of Fluorad FC—431™ surfactant (a 3M Company tradename for a fluorocarbon surfactant described as a short-chain oligomeric ester wherein the ester group is fluorinated).

The supporting film of the conductive substrate comprised an optically transparent, 4.7 mil (0.12 cm) thick polyethylene terephthalate film subbed to provide adhesion with the electrically conducting layer.

The dielectric support on the photoconductive layer comprised a blend of poly(vinylacetate-co-crotonic acid, 95/5 mole ratio) and cellulose acetate butyrate in a ratio by weight of 80:20. Several elements were formed with dielectric supports having uniform thicknesses of 0.5, 1.6 or 2.4 micrometers on each respective element.

Example 1

Multicolor proofing method

The element described in Preparation A having a 2.4-micrometer thick dielectric support was employed in a color proofing process of the invention. A color separation negative was mounted on a vacuum platen composed of quartz glass for transparency. The color imaging element was placed in register over the separation negative with the dielectric support surface facing away from and the transparent polymeric film substrate facing toward the negative. To form the first toner separation image on the dielectric support, the latter was overall-charged to +600 volts. Thereafter, the photoconductive layer was imagewise-exposed through the platen, separation negative, transparent supporting film, conductive layer, and barrier layer, to form a latent electrostatic image in the dielectric support. The latent image was developed with a self-fixing liquid electrographic developer containing black-pigmented toner particles in an electrically insulating carrier liquid, followed by a vacuum drying step and a rinse in clear carrier liquid. The developed image on the dielectric support was then fused by drying in air. The procedure was repeated three times with cyan-, magenta- and yellow-colored self-fixing developers, respectively, to form a composite multicolor toner image on the dielectric support.

The imaging element bearing the multicolor toner image was then moved to a separate lamination device comprising heated metal and rubber rolls, together forming a nip. The toner image was passed through the nip with and against a white receiver paper at a roll temperature of 100°C (212°F) and a pressure of 225 pounds per square inch (1.551 MPa) to effect transfer of the dielectric support and composite image to the receiver followed by peeling off the rest of the imaging element. The resulting multicolor proof presented a multicolor toner image against a white paper background and protected by the dielectric support, thus accurately resembling a multicolor print from a full press run.

The black toner employed in the developer composition comprised, as binder, the polyester poly[neopentyl-4-methylcyclohexene-1,2-dicarboxylatecoterephthalate-co-5-(N-potassio-*p*-toluenesulfonamidosulfonyl)isophthalate)] 50/45/5; as colorant, carbon black and alkali blue dye; wax; and dispersing agent for the wax, with the ratio of the weight of the wax plus dispersing agent for wax to the weight of binder being at least 0.25. In the cyan, magenta and yellow toners, the black colorants were replaced with Sunfast Blue NF (Sun Chemical Co.), Bonadur Red (Sun Chemical Co.) and Ragoon Yellow (Sun Chemical Co.), respectively.

Preparation B

Imaging element with releasable photoconductive layer

An element as described in Preparation A is prepared, but omitting the overcoat as the releasable dielectric support. Suitable addenda are incorporated into the photoconductive layer to promote its releasability from the electrically conducting substrate. Preferably, the binder polymer employed in the photoconductive layer is selected from among relatively high Tg materials to provide a barrier to dark charge injection and unwanted injection of photogenerated charge carriers.

Similar results can be expected when this element is employed instead of the element of Preparation A in the method described in Example 1.

**Claims**

1. A color imaging method comprising forming a multicolor image record comprising a plurality of overlapping color images on a receiving element, characterized by:

(I) forming a first color image on the dielectric support of an electrophotographic proofing element comprising,

(a) a photoconductive layer on an electrically conductive substrate capable of transmitting actinic radiation to which the photoconductive layer is responsive and

(b) a dielectric support releasably adhered to the rest of the element and forming an electrostatically chargeable surface of the element, said support comprising said photoconductive layer or an overcoat thereof, by

(i) overall charging the surface of the dielectric support,

(ii) imagewise-exposing the photoconductive layer to actinic radiation to form a first electrostatic image on the surface of the dielectric support, and

(iii) developing the first electrostatic image with a first color developer composition to form the first color image,

(II) forming a second color image overlapping the first color image on the surface of the dielectric support by

(iv) overall charging the surface of the dielectric support and first color image,

(v) while the dielectric support and first color image are still charged, imagewise-exposing the photoconductive layer to actinic radiation through the substrate to form a second electrostatic image, and

(vi) developing the second electrostatic image with a second color developer composition to form the second color image,

(III) contacting the surface of the dielectric support having the color images thereon with a receiving element, and

(IV) transferring the dielectric support and color images to the receiving element to form the multicolor image record and peeling off the rest of the element.

2. A color imaging method as described in Claim 1 wherein said dielectric support comprises an overcoat releasably adhered to said photoconductive layer.

3. A color imaging method as described in Claim 1 wherein, prior to step (III), steps (II)—(iv) through (II)—(vi) are repeated to form third and fourth color images, thereby forming a composite of four overlapping toner images on said dielectric support.

4. A color imaging method as described in Claim 1 wherein said receiving element comprises a paper sheet.

5. A color imaging method as described in Claim 1 wherein the developer composition employed in the formation of each image is a liquid electrographic developer comprising an electrically insulating carrier liquid and toner colorant particles dispersed in said carrier liquid.

6. A color imaging method as described in Claim 1 wherein said dielectric support is transparent.

7. A color imaging method as described in Claim 2 wherein said photoconductive layer contains a release agent to enhance the releasability of said dielectric support from said photoconductive layer, and wherein said release agent comprises a block copolyester containing polysiloxane recurring units.

8. A color imaging method as described in Claim 1 wherein said photoconductive layer is sensitive to actinic radiation below 400 nm only and exhibits nonpersistent conductivity.

9. A color imaging method as described in Claim 8 wherein said photoconductive layer comprises an arylalkane leuco base photoconductor.

**Patentansprüche**

1. Farbabbildungsverfahren, bei dem man eine mehrfarbige Bildaufzeichnung mit einer Vielzahl von sich überlappenden Farbbildern auf einem Empfangselement erzeugt, dadurch gekennzeichnet, daß man:

(I) auf dem dielektrischen Träger eines elektrophotographischen Probeelementes ein erstes Farbbild erzeugt, wobei das Probeelement aufweist:

(a) eine photoleitfähige Schicht auf einem elektrisch leitfähigen Substrat, das für aktinische Strahlung durchlässig ist, demgegenüber die photoleitfähige Schicht ansprechbar ist, und

(b) einen dielektrischen Träger, der lösbar am Rest des Elementes haftet und eine elektrostatisch aufladbare Oberfläche des Elementes bildet, wobei der Träger die photoleitfähige Schicht oder eine Deckschicht davon aufweist, durch

(i) Aufladen der Oberfläche des dielektrischen Trägers,

(ii) bildweise Belichtung der photoleitfähigen Shicht mit aktinischer Strahlung zwecks Erzeugung eines ersten elektrostatischen Bildes auf der Oberfläche des dielektrischen Trägers und

(iii) Entwicklung des ersten elektrostatischen Bildes mit einer ersten Farbentwicklerzusammensetzung zwecks Erzeugung des ersten Farbbildes, daß man

(II) auf der Oberfläche des dielektrischen Trägers ein zweites Farbbild erzeugt, das das erste Farbbild überlappt, indem man

(iv) die Oberfläche des dielektrischen Trägers und das erste Farbbild auflädt,

(v) die photoleitfähige Schicht durch das Substrat zwecks Erzeugung eines zweiten elektrostatischen Bildes mit aktinischer Strahlung bildweise exponiert, während der dielektrische Träger und das erste Farbbild noch aufgeladen sind, und

(iv) das zweite elektrostatische Bild mit einer zweiten Farbentwicklerzusammensetzung zwecks Erzeugung des zweiten Farbbildes entwickelt, daß man

(III) die Oberfläche des dielektrischen Trägers mit den darauf befindlichen Farbbildern mit einem Bildempfangselement in Kontakt bringt, und daß man

(IV) den dielektrischen Träger und die Farbbilder zwecks Erzeugung der mehrfarbigen Bildaufzeichnung auf das Empfangselement überträgt und den Rest des Elementes abzieht.

2. Farbabbildungsverfahren nach Anspruch 1, bei dem der dielektrische Träger eine Deckschicht aufweist, die lösbar an der photoleitfähigen Schicht haftet.

3. Farbabbildungsverfahren nach Anspruch 1, in dem vor der Stufe (III) die Stufen (II)—(iv) bis (II)—(vi) zwecks Erzeugung von dritten und vierten Farbbildern wiederholt werden, so daß ein Verbund von vier sich überlappenden Tonerbildern auf dem dielectrischen Träger erzeugt wird.

4. Farbabbildungsverfahren nach Anspruch 1, in dem das Empfangselement ein Papierblatt ist.

5. Farbabbildungsverfahren nach Anspruch 1, in dem die Entwicklerzusammensetzung, die zur Erzeugung eines jeden Bildes verwendet wird, ein flüssiger elektrographischer Entwickler mit einer elektrisch isolierenden Trägerflüssigkeit und Farbtonerteilchen, die in der Trägerflüssigkeit dispergiert sind, ist.

6. Farbabbildungsverfahren nach Anspruch 1, in dem der dielektrische Träger transparent ist.

7. Farbabbildungsverfahren nach Anspruch 2, in dem die photoleitfähige Schicht ein Trennmittel enthält, um die Abtrennbarkeit des dielektrischen Trägers von der photoleitfähigen Schicht zu erleichtern und in dem das Trennmittel ein Block-Copolyester mit wiederkehrenden Polysiloxaneinheiten ist.

8. Farbabbildungsverfahren nach Anspruch 1, in dem die photoleitfähige Schicht nur gegenüber aktinischer Strahlung unterhalb 400 nm empfindlich ist une eine nicht-persistente Leitfähigkeit aufweist.

9. Farbabbildungsverfahren nach Anspruch 8, in dem die photoleitfähige Schicht einen Arylalkan-Leukobasen-Photoleiter aufweist.

**Revendications**

1. Procédé de formation d'image en couleurs consistant à former un enregistrement d'image pour épreuve multicolore comprenant plusieurs images en couleurs superposées sur un élément récepteur, caractérisé en ce que:

(I) On forme une première image en couleurs sur le support diélectrique d'un produit électrophotographique pour épreuve comprenant:

a) une couche photoconductrice sur un substrat électriquement conducteur capable de transmettre le rayonnement actinique auquel la couche photoconductrice est sensible,

b) un support diélectrique adhérant de façon pelliculable au reste du produit et formant une surface électrostatiquement chargeable du produit, constitué soit de la couche photoconductrice elle-même, soit d'une surcouche de celli-ci,

(i) en chargeant toute la surface du support diélectrique,

(ii) en exposant suivant une image la couche photoconductrice à un rayonnement actinique pour former une première image électrostatique sur la surface du support diélectrique,

(iii) en développant cette première image électrostatique avec un premier révélateur couleur pour former une première image en couleur,

(II) On forme une seconde iamge en couleur recouvrant la première sur la surface du support diélectrique

(iv) en chargeant toute la surface du support diélectrique et de la première image en couleur,

(v) tandis que le support diélectrique et la première image en couleur sont encore chargés, en exposant suivant une image la couche photoconductrice à un rayonnement actinique à travers le substrat pour former une seconde image électrostatique,

(vi) et en développant la seconde image électrostatique avec un second révélateur couleur por former une seconde image en couleur,

(III) on met en contact la surface du support diélectrique portant les images en couleur avec un élément récepteur,

(IV) on transfère le support diélectrique et les images en couleur sur l'élément récepteur pour former l'enregistrement d'image pour épreuve multicolore, et on pellicule le reste du produit.

2. Procédé de formation d'image en couleurs selon la revendication 1, dans lequel le support diélectrique est formé d'une surcouche adhérant de façon pelliculable à la couche photoconductrice.

3. Procédé de formation d'image en couleurs selon la revendication 1, dans lequel, avant l'étape III, on répète les étapes II—(iv) à II—(vi) pour former une troisième et une quatrième image en couleur, formant ainsi une image composite de quatre images superposées sur le support diélectrique.

4. Procédé de formation d'image en couleurs selon la revendication 1, dans lequel l'élément récepteur est une feuille de papier.

5. Procédé de formation d'image en couleurs selon la revendication 1, dans lequel le révélateur utilisé dans la formation de chaque image est un révélateur électrographique liquide comprenant un véhicule liquid électriquement isolant et des particules de colorant développateur dispersées dans le véhicule liquide.

6. Procédé de formation d'image en couleurs selon la revendication 1, dans lequel le support diélectrique est transparent.

7. Procédé de formation d'image en couleurs selon la revendication 2, dans lequel le couche photoconductrice contient un agent de pelliculage pour améliorer la séparation du support diélectrique de la couche photoconductrice, et dans lequel ledit agent de pelliculage est un copolyester bloqué contenant des motifs polysiloxane.

8. Procédé de formation d'image en couleurs selon la revendication 1, dans lequel le couche photoconductrice n'est sensible qu'à un rayonnement actinique inférieur à 400 nm et présente une conductivité non persistante.

9. Procédé de formation d'image en couleurs selon la revendication 8, dans lequel la couche photoconductrice comprend comme photoconducteur une base leuco arylalkane.

FIG. 1

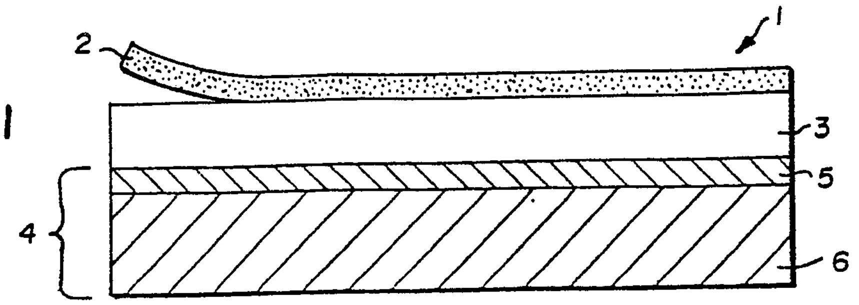


FIG. 2

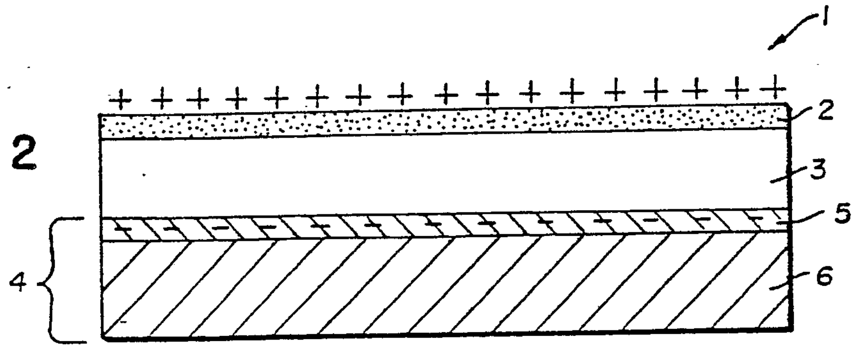


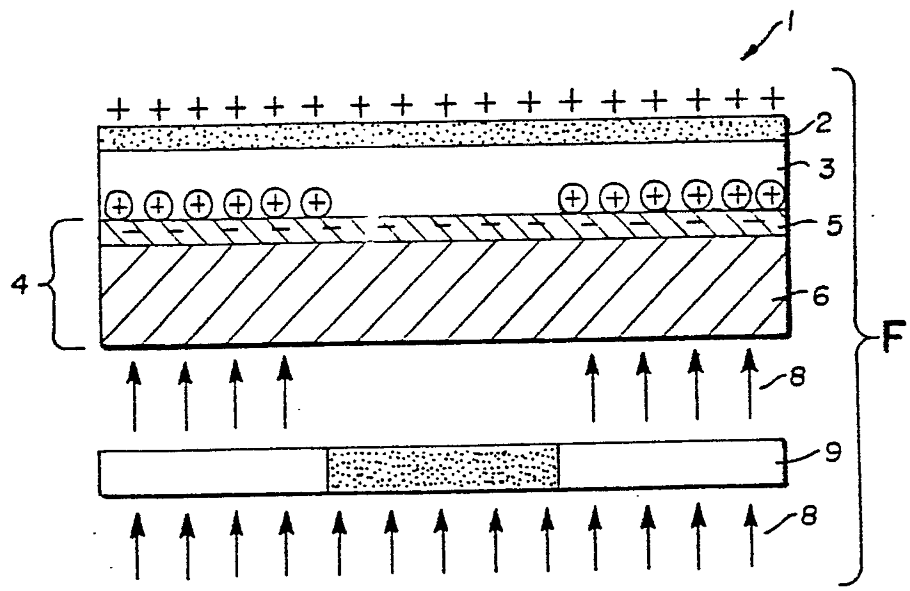


FIG. 3

FIG. 4

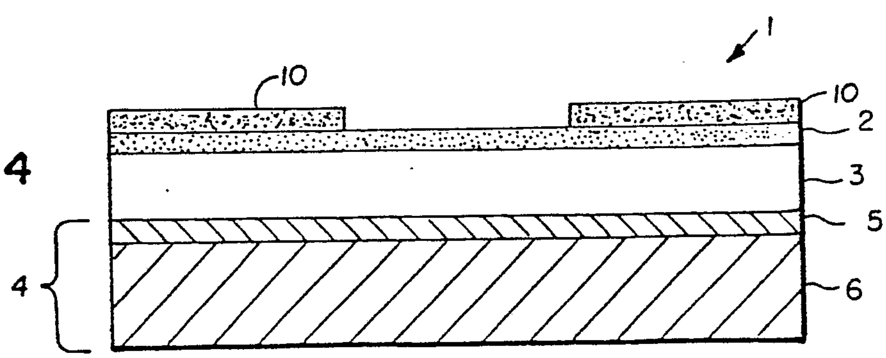

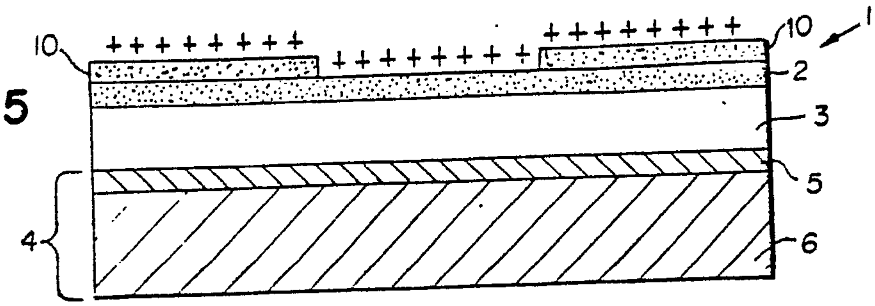


FIG. 5

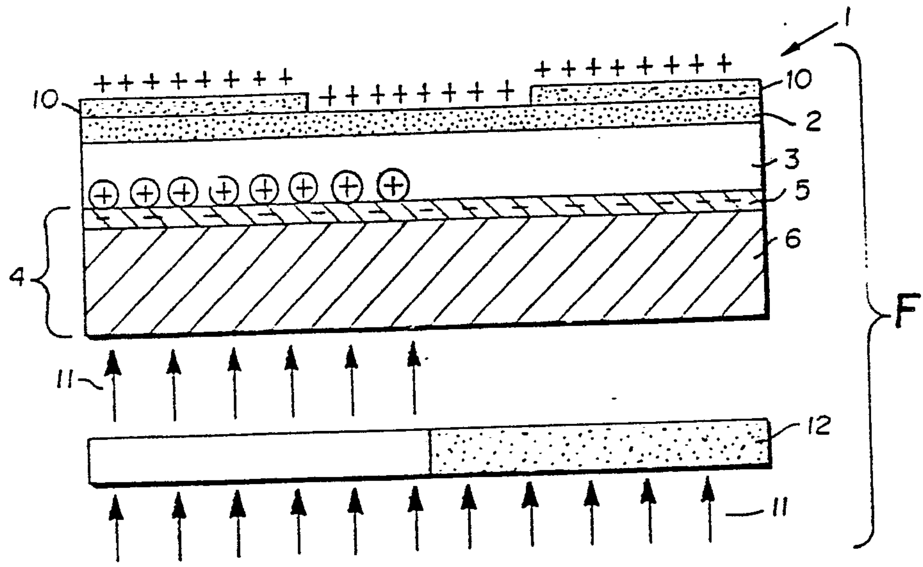


FIG. 6

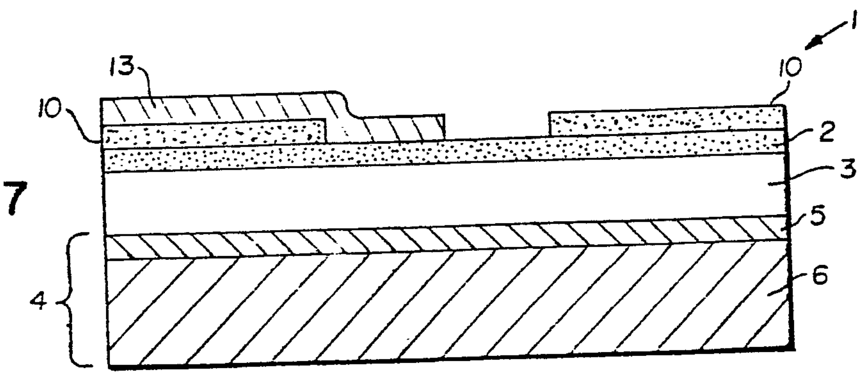


FIG. 7

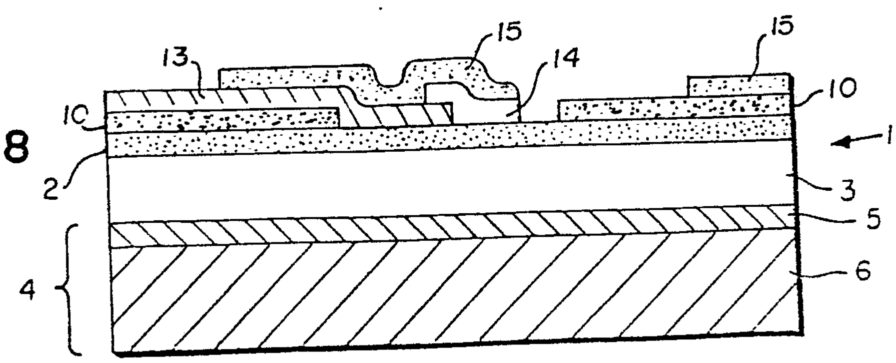


FIG. 8

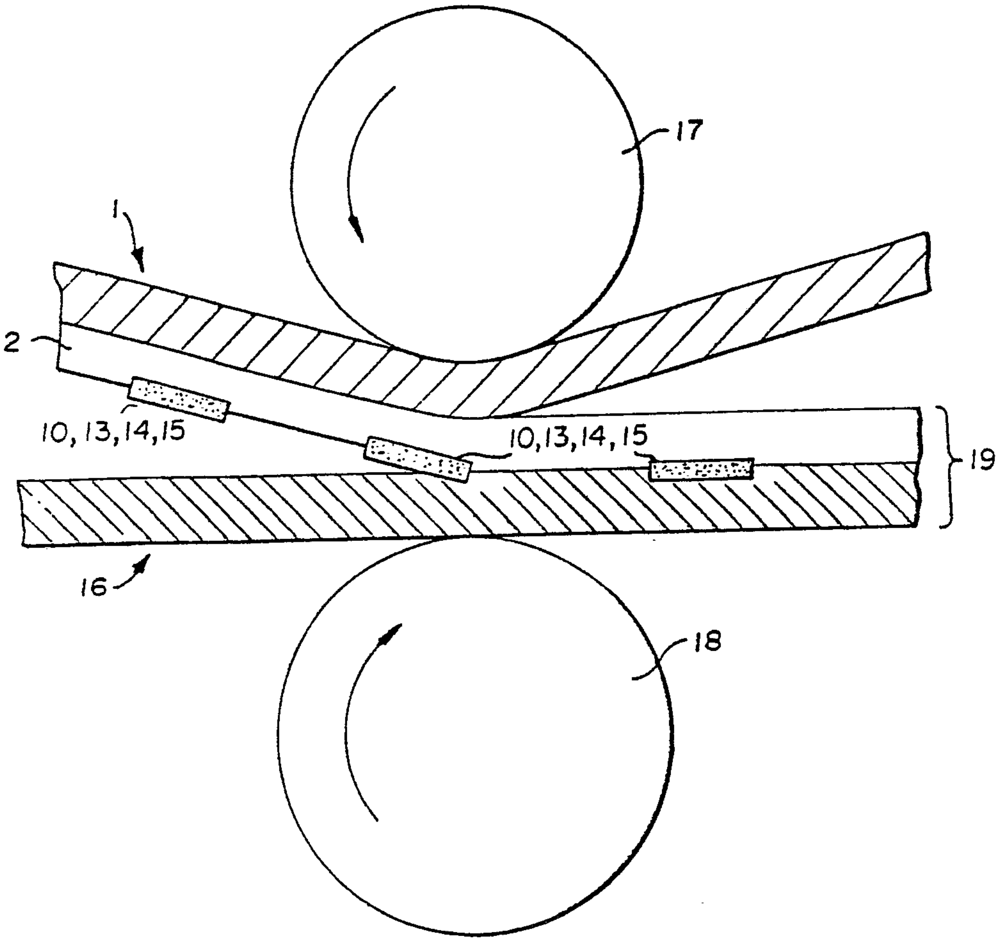


FIG. 9